# EUROPEAN PATENT APPLICATION

(11) **EP 0 762 518 A2**
(43) Date of publication of application: **12.03.1997**
(21) Application number: 96306593.3
(22) Date of filing: 11.09.1996
(51) Int. Cl.: H01L 33/00, H01L 21/00

(54) **Improvements in or relating to semiconductor devices**

(30) Priority: 11.09.1995 US 3568
(71) Applicant: TEXAS INSTRUMENTS INCORPORATED, Dallas Texas 75265 (US)
(72) Inventor: Abbott, Donald C., Norton, MA 02766 (US); Bawa, Mohendra S., Plano, TX 75023 (US)
(74) Representative: Nettleton, John Victor

(57) **Abstract**

The invention is to a method for producing a silicon substrate by masking a substrate (31) to define a deposition area. The silicon, in the form of a gas, is deposited (33) with the silicon onto the deposition area. Deposition is made by a plasma deposition with the substrate under a non-oxygen bearing gas or liquid (32) to prevent the formation of silica.

## Description

### FIELD OF THE INVENTION

This invention relates to silicon semiconductor devices, and more particularly to a method for making silicon coated substrates.

### BACKGROUND OF THE INVENTION

Silicon and silicon coated substrates are useful in forming such devices as silicon based solar cells. Solar cells have been formed of silicon wafers, and substrates covered with a layer of silicon material. Solid silicon substrates are not cost effective. Substrates of silicon deposited on a substrate base usually have an evenly deposited layer of silicon which produce a minimum surface area and are produced by depositing a single material, the silicon.

### SUMMARY OF THE INVENTION

The invention is related to a method for producing a silicon substrate using a plasma gun or torch, a mask is positioned over a deposition substrate to define a deposition area, a plasma directed onto a substrate through a non-oxygen bearing gas shrouding the substrate and a silicon bearing material is introduced into the plasma to deposit silicon onto the substrate.

### BRIEF DESCRIPTION OF THE DRAWINGS

The present invention will now be further described, by way of example, with reference to the accompanying drawings in which:
FIGURE 1 shows an exploded view of a jig, including the mask, for use in masking off areas where silicon is not to be deposited, and to precisely expose the area of the deposition for use in the method of the present invention;
FIGURE 2 shows the mask of Figure 1 held in position by index pins;
FIGURE 3 shows a pair of circular openings in the mask of Figures 1 & 2;
FIGURE 4 shows an alternative rectangular mask with index holes extended therethrough for use in the method of the invention;
FIGURE 5 is a flow diagram showing the process of the method of the invention; and
FIGURE 6 is a pictorial representation of a plasma torch.

### DESCRIPTION OF A PREFERRED EMBODIMENT

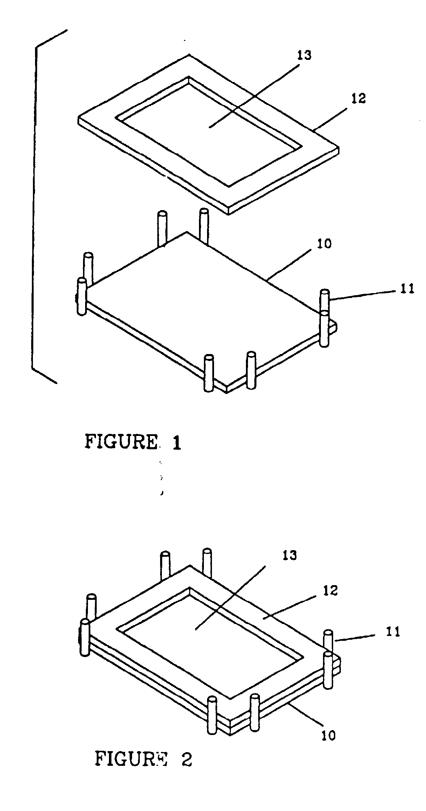

Figure 1 shows an exploded view of a jig, including the mask, useful in masking off areas where silicon is not to be deposited. A substrate 10 is positioned between a plurality of pins 11 used to position and hold the substrate 10 in place. A mask 12 with an aperture therein is shown positioned above substrate 10. The positioning of the mask can be critical where multiple depositions are to be made, one on top of the other.

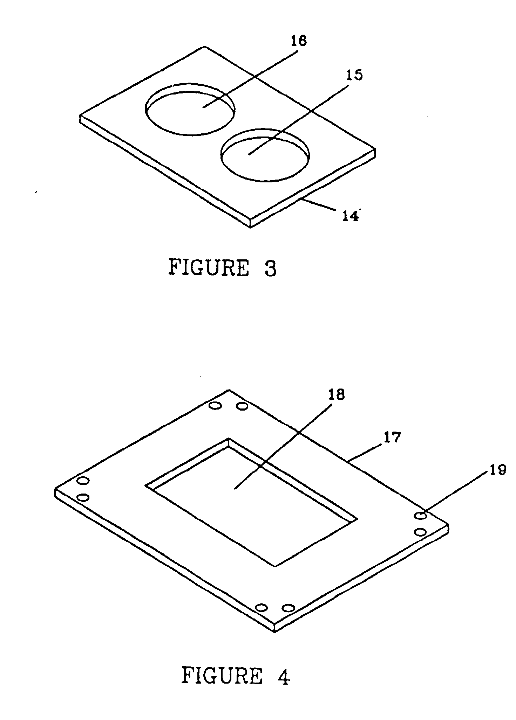

Figure 2 shows the mask 12 positioned on top of substrate 10 and held in position by index pins 11. Index pins 11 assure that the aperture 13 in mask 12 is located in the precise location at which material is to be deposited.

Figure 3 shows another embodiment of a mask in which there are to be two deposition areas. Mask 14 is positioned and indexed into a desired position by index pins 11 (as illustrated with reference to Figures 1 and 2) to exactly position apertures 15 and 16 in a desired position over substrate 10.

In Figures 1-3, a flat substrate is illustrated, however substrates may be, for example flat, spherical or any other non-flat shape. The substrates may be, for example, such materials as glass, aluminum, silicon, or any other material on which silicon may be deposited.

Figure 4 is another embodiment of a mask in which an aperture 18 in mask 17 is positioned in an exact position by index pins 11. In this embodiment, index pins 11 extend through index holes 19 in mask 17 to exactly position mask 17, and aperture 18, over a substrate.

Additional masks may be constructed to allow selectively depositing metal, such as aluminum, gold or silver, as a substrate or as contacts. The depositions may be either before or after depositing silicon. Other photovoltaic effective coatings may also be deposited either before or after the deposition of silicon. The silicon precursor may be pre-doped to provide N-type and/or P-type silicon. Multiple coatings may be applied, for example, N-type, P-type, intrinsic, poly-crystal, micro-crystalline, and amorphous silicon to form solar cells of different configurations.

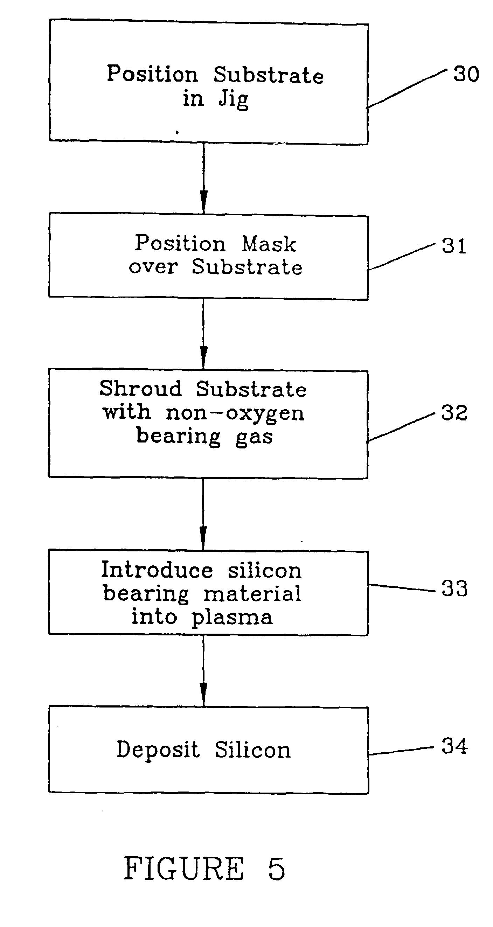

Figure 5 is a flow diagram showing an example of the process of the method of the invention. References are herein made to reference numbers of Figures 1 and 2. A substrate 10 is fixed in position in a fixture (Step 30) and a mask 12 with at least one window or aperture 13 is located over substrate 10 in a precise position with index pins (Step 31). Mask 12 may be of metal, glass, plastic or similar material.

A shroud gas is introduced (Step 32) into the plasma reactor to surround the substrate during deposition. This is done to prevent the formation of silica by the reaction of silicon and oxygen at elevated temperatures.

Next, one of Silane gas (SiH₄) or Silicon Tetrachloride gas (SiCl₄) is introduced into the plasma to deposit silicon onto the gas shrouded substrate (Step 33). Then, silicon is deposited (Step 34) onto the substrate.

The use of Silane gas (SiH₄) or Silicon Tetrachloride gas (SiCl₄) is in contrast to conventional plasma coating techniques that rely on finely divided powders as the source of the coating material. Other photovoltaic materials, such as gallium arsenide, may be plasma sprayed onto the high surface silicon.

This process produces a silicon substrate which is prepared by plasma deposition on a base substrate. The silicon surface can be subsequently coated with additional silicon or other materials to form a high surface area solar cell.

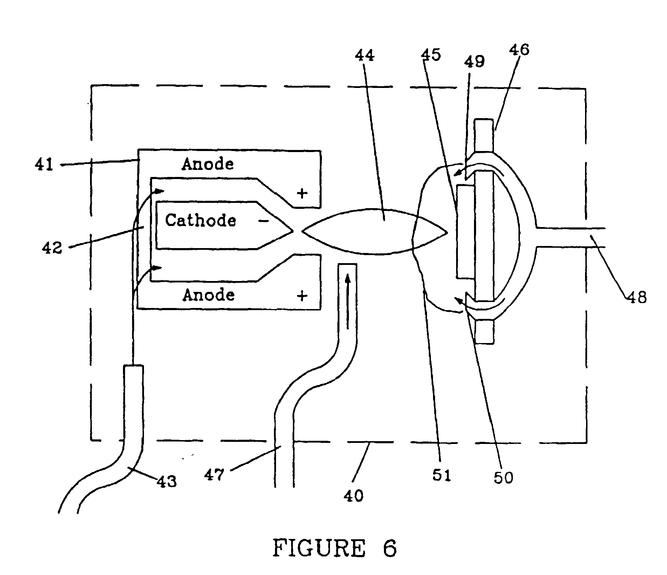

Figure 6 is a pictorial representation of a plasma torch or gun which can be used in the process of the present invention. Reactor 40 includes an anode 41 around a cathode 42. Gas is introduced into inlet 43 and directed through the anode/cathode assembly 41/42 to produce the plasma flame 44 which is directed at a substrate 45 on a mounting plate 46. Either Silane gas (SiH₄) or Silicon Tetrachloride gas (SiCl₄) is introduced into the reactor 40 at inlet 47. The silicon bearing gas is directed into the plasma flame 44 and deposited on the surface of substrate 45.

To provide an oxygen-free environment, a gas such as argon or nitrogen is introduced through gas inlet 48 and then through outlets 49 and 50 to provide gas shroud 51. Optionally, hydrogen may be introduced along with one of argon or nitrogen as a secondary gas. Two outlets 49 and 50 are illustrated, but multiple outlets or one circular outlet surrounding substrate 46 may be used.

## Claims

1. A method for producing a silicon substrate comprising the steps of:
positioning a mask over a deposition substrate to define a deposition area;
directing a plasma onto the substrate;
shrouding the substrate with a non-oxygen bearing gas;
introducing a silicon bearing material into the plasma to deposit silicon onto the substrate.

2. The method according to Claim 1, wherein the step of depositing silicon comprises depositing silicon onto the substrate through the shrouding gas.

3. The method according to Claim 1 or Claim 2, wherein the step of introducing the silicon bearing material comprises introducing a silicon bearing materials selected from one of Silane gas (SiH₄) and Silicon Tetrachloride gas (SiCl₄).

4. The method according to any preceding claim, wherein the shrouding step comprises introducing a gas which is selected from at least one of argon and nitrogen.

5. The method according to Claim 4, wherein the shrouding step comprises introducing hydrogen as a secondary gas.

6. The method according to any preceding claim, further comprising the step of depositing at least one additional layer of material to form a solar cell.

7. The method according to any preceding claim, further comprising performing each of the positioning, directing, shrouding and introducing steps in a plasma reactor.

8. A plasma reactor for use in depositing material on a substrate, comprising:
an anode and cathode for forming a plasma within the plasma reactor;
a first inlet for introducing a gas to form the plasma in combination with the anode and cathode;
a second inlet for introducing material into the plasma which is to be deposited onto the substrate; and
a third inlet for introducing a gas to shroud the substrate.
